# FASCICULE DE BREVET EUROPEEN

(11) **EP 2 865 099 B1**
(45) Date de publication et mention de la délivrance du brevet: **31.08.2016**
(21) Numéro de dépôt: 13733265.6
(22) Date de dépôt: 26.06.2013
(51) Int. Cl.: H03M 13/45

(54) **CORRECTION D'ERREURS DOUBLES DE BITS DANS UN MOT DE CODE AVEC DISTANCE DE HAMMING TROIS OU QUATRE**
KORREKTUR VON DOPPELBITFEHLERN IN EINEM CODEWORT MIT HAMMINGDISTANZ DREI ODER VIER
CORRECTION OF DOUBLE BIT ERRORS IN A CODE WORD WITH HAMMING DISTANCE THREE OR FOUR

(30) Priorité: 26.06.2012 FR 1256029; 10.08.2012 FR 1202226
(43) Date de publication de la demande: 29.04.2015
(73) Titulaire: Commissariat à l'Énergie Atomique et aux Énergies Alternatives, 75015 Paris (FR)
(72) Inventeur: EVAIN, Samuel, F-91400 Saclay (FR); GHERMAN, Valentin, F-91120 Palaiseau (FR)
(74) Mandataire: Dudouit, Isabelle
(86) Numéro de dépôt international: PCT/EP2013/063405
(87) Numéro de publication internationale: WO 2014/001395

(56) Documents cités:
- EP-A1- 1 819 058
- US-A1- 2007 214 402
- "4.4 The Chase Algorithm" In: G. C. jr Clark, J. Bibb Cain: "Error-Correction Coding for Digital Communications", 30 juin 1981 (1981-06-30), Springer, XP009168642, ISBN: 0306406152 pages 167-172, le document en entier
- BACCARINI L ET AL: "Error-correction techniques and adaptive linearization in SDH radio", EUROPEAN CONFERENCE ON RADIO RELAY SYSTEMS. EDINBURGH, OCT. 11 - 14, 1993; LONDON, IEE, GB, vol. CONF. 4, octobre 1993 (1993-10), pages 238-243, XP006513627, ISBN: 978-0-85296-594-8

## Description

L'invention a pour objet un procédé et un dispositif de détermination et de correction d'erreurs doubles bits dans un mot de code pourvu d'une distance minimale de Hamming égale seulement à 3 ou 4. L'invention propose un dispositif exploitant judicieusement des informations de confiance sur les bits d'un mot de code affecté d'une erreur sur un ou deux bits afin de corriger cette erreur. L'invention s'applique notamment aux domaines des codes correcteurs d'erreurs et des technologies nanométriques.

Dans un système numérique, les données sont habituellement stockées et/ou transmises sous forme de valeurs binaires appelées bits. Ces données peuvent être affectées par des fautes qui peuvent engendrer des erreurs de fonctionnement et finalement la défaillance du système en l'absence de mécanisme de correction ou masquage.

Afin de garantir un niveau d'intégrité acceptable pour les données mémorisées ou transmises, certains systèmes électroniques utilisent des codes, désignés habituellement par l'acronyme ECC venant de l'expression anglo-saxonne « Error Correcting Codes». A cet effet, les données sont encodées lors de l'écriture desdites données dans un système de stockage ou lors de la transmission desdites données à travers un système d'interconnexions. Lors de l'encodage des données avec un code ECC, des bits de vérification sont ajoutés aux bits de données afin de former des mots de code.

Afin de permettre la correction des erreurs qui affectent jusqu'à n bits dans les mots d'un code ECC, ces mots de code doivent être séparés par une distance minimale de Hamming de 2n+1. Pour permettre également la détection des erreurs qui affectent n+1 bits, en dehors de la correction des erreurs affectant jusqu'à n bits, dans les mots de code d'un ECC, ces mots de code doivent être séparés par une distance minimale de Hamming de 2n+2.

Les mots de code d'un code correcteur linéaire sont définis à l'aide d'une matrice de contrôle H. Un vecteur binaire V est un mot de code seulement si son produit avec la matrice H génère un vecteur nul. Un mot de code V d'un code correcteur linéaire est vérifié en évaluant le produit matriciel H·V. Le résultat de cette opération est un vecteur appelé syndrome. Si le syndrome est un vecteur nul, le mot de code V est considéré comme correct. Un syndrome non-nul indique la présence d'au moins une erreur. Si le syndrome permet d'identifier les positions des bits affectés, les erreurs affectant le mot de code peuvent être corrigées.

Différents codes ECC linéaires existent avec des capacités de détection et de correction d'erreurs différentes. A titre d'exemple, un code de Hamming permet de corriger une erreur simple, c'est-à-dire une erreur qui affecte un seul bit. Cette capacité de correction est qualifiée de SEC, acronyme venant de l'expression anglo-saxonne «Single Error Correction». Les mots d'un code SEC sont séparés par une distance minimale de Hamming de 3.

Un autre exemple de code ECC est le code DEC, acronyme venant de l'expression anglo-saxonne «Double Error Correction», qui permet la correction d'erreurs doubles, c'est-à-dire d'erreurs affectant deux bits dans un mot de code. Bien évidemment, les codes de cette famille sont aussi capables de corriger toutes les erreurs simples. Les mots d'un code DEC sont séparés par une distance minimale de Hamming de 5.

Cette différence entre la capacité de correction d'un code SEC et celle d'un code DEC est due à une augmentation du nombre de bits de vérification dans le cas d'un code DEC. Par exemple, pour huit bits de données un code SEC a besoin de quatre bits de vérifications tandis qu'un code DEC a besoin de huit bits de vérification. Une telle augmentation de 100% du nombre de bits de vérification peut être prohibitive en raison de l'impact sur la surface des composants, leur rendement, leur consommation et finalement leur coût.

Or, les mémoires manufacturées à l'aide des technologies émergentes, comme les MRAMs, acronyme venant de l'expression anglo-saxonne «Magnetic Random Access Mémory», peuvent être affectées par un taux important d'erreurs transitoires et/ou permanentes. Pour ces types de mémoires, la capacité de correction des codes SEC est trop faible et les codes DEC restent trop chers. Dans de telles situations, des solutions innovantes de masquage et/ou corrections sont nécessaires.

Le document EP 1 819 058 concerne un procédé et un système utilisant les codes CRC pour une correction d'erreur additionnelle en plus d'une capacité de détection d'erreur.

Le document intitulé « the Chase Algorithm » In G.C.jr Clark, J.Bibb Cain : Error-Correction coding for Digital Communications », 30 juin 1981, Springer, XP009168642 décrit l'algorithme Chase dans lequel on forme un syndrome et on utilise la localisation du symbole le plus faible pour choisir dans la table le mot de code le plus proche.

Le document de Bacarini intitulé « Error-Correction techniques and adaptive linearization in SDH radio », Europen conférence on radio relay systems, Edinburgh, oct.11-14, 1993, XP006513627 décrit un schéma de décodage d'un code de Hamming étendu corrigeant une erreur double par inversion du bit le moins fiable suivi d'une correction d'erreur unique.

La demande de brevet US 2007/214402 divulgue une méthode de décodage d'un code de Hamming dans le domaine Bluetooth, dans laquelle un motif de deux erreurs correspondant au syndrome est sélectionné en fonction d'une métrique.

Un but de l'invention est notamment de proposer une méthode pour déterminer les bits erronés d'une erreur double, c'est-à-dire une erreur sur deux bits, dans un mot de code dont la distance minimale de Hamming est inférieure à 5. A cet effet, l'invention a pour objet un procédé tel que défini dans la revendication 1.

Le procédé permet ainsi de corriger des erreurs double pour un code pourvu d'une distance minimale de Hamming de 3 ou 4 en identifiant, parmi toutes les erreurs possibles produisant le mot initial, une erreur double dont les bits affectés correspondent tous les deux à des bits de faible confiance. Cette étape permet de discriminer les erreurs lorsque le cas le plus favorable ne se réalise pas, autrement dit si parmi toutes les erreurs double produisant le mot initial, aucune erreur ne contient deux bits de faible confiance. Dans ce cas, le procédé recherche une erreur double dont l'un des deux bits est affecté d'un faible niveau de confiance.

Selon une variante de réalisation, le procédé comprend une étape préalable de test où l'on vérifie si le syndrome issu du mot initial correspond à celui d'une erreur double générant un syndrome différent de tous les syndromes produits par une erreur simple et si au moins un bit du mot initial est affecté d'un faible niveau de confiance; si le test est négatif, aucun bit erroné n'est indiqué.

L'invention a également pour objet un procédé de correction d'une erreur double dans un mot binaire initial comprenant les étapes du procédé de détermination tel que décrit plus haut, et une étape d'inversion du ou des bits erronés déterminés par ledit procédé de détermination.

L'invention a également pour objet un procédé de correction des bits erronés dans un mot binaire initial affecté d'une erreur simple ou d'une erreur double et issu d'un code muni d'une distance minimale de Hamming égale à 3 ou 4, dans lequel lorsque le syndrome issu du mot initial correspond à une erreur double, on exécute le procédé de correction d'une erreur double tel que présenté plus haut, et dans lequel lorsque ledit syndrome correspond à une erreur simple, on exécute une correction d'erreur simple sur le mot initial.

L'invention a également pour objet un dispositif de correction des bits erronés dans un mot initial binaire affecté d'une erreur double ou simple et issu d'un code muni d'une distance minimale de Hamming égale à 3 ou 4, tel que défini dans la revendication 5.

L'invention a également pour objet un module mémoire comprenant un dispositif de correction tel que décrit plus haut.

D'autres caractéristiques et avantages de l'invention apparaîtront à l'aide de la description qui suit, donnée à titre illustratif et non limitatif et faite en regard des dessins annexés parmi lesquels :
- la figure 1, un exemple de dispositif selon l'invention permettant notamment la correction des erreurs simples et doubles dans un mot d'un code caractérisé par une distance minimale de Hamming égale à 3 ou 4;
- la figure 2, un exemple de procédé selon l'invention pour sélectionner une erreur double parmi plusieurs erreurs doubles produisant un même syndrome.

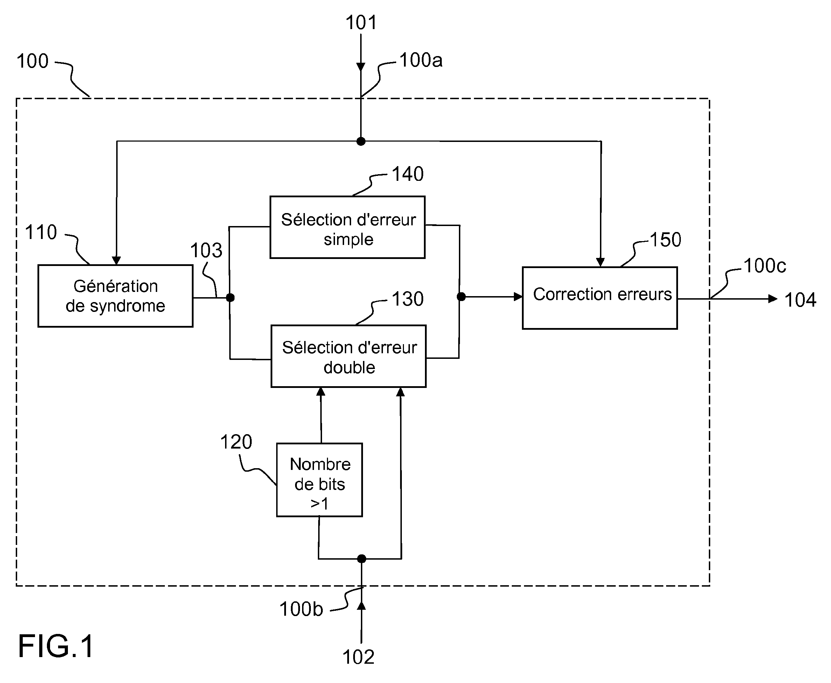

La figure 1 présente un exemple de dispositif selon l'invention permettant notamment la correction des erreurs simples et doubles dans un mot d'un code pourvu d'une distance minimale de Hamming égale à 3 ou 4 - autrement dit, la plus petite distance de Hamming séparant deux mots de ce code est égale à 3 ou 4.

Dans la suite, il est considéré qu'une donnée indicative de confiance, dans l'exemple sous la forme d'un mot 102, est utilisée pour indiquer un niveau binaire de confiance de chaque bit dans un mot de code 101, dit mot initial 101, à l'entrée du dispositif selon l'invention. Dans les exemples développés, le mot initial 101 et le mot de confiance 102 comprennent le même nombre de bits et certains bits dans le mot initial 101 peuvent être erronés. Sans affecter la généralité de l'invention, il est également considéré par la suite que dans le mot de confiance 102, un bit avec la valeur 1-logique signale que le bit correspondant dans le mot initial 101 a un faible niveau de confiance, un bit avec la valeur 0-logique signalant un bit avec un fort niveau de confiance. Le mot initial binaire peut être affecté d'une erreur double ou simple.

Le dispositif 100 reçoit sur une première entrée 100a un mot initial 101 et sur une deuxième entrée 100b un mot de confiance 102 comprenant l'information binaire relative au niveau de confiance de chaque bit dans le mot initial 101. Ce mot de confiance 102 est utilisé pour permettre la correction des erreurs doubles qui génèrent un syndrome différent de tous les syndromes produits par une erreur simple. Le dispositif 100 délivre en sortie 100c un mot corrigé 104.

Le dispositif selon l'invention 100 comprend un module de génération de syndrome 110 alimenté par le mot initial 101, un module de sélection d'erreur simple 140, un module de sélection d'erreur double 130, un module de correction d'erreurs 150, ainsi qu'un module de test 120 apte à déterminer si le nombre de bits de faible confiance dans le mot initial est supérieur ou égal à 1.

Le module de génération de syndrome 110 reçoit en entrée le mot initial 101 et génère un syndrome à partir des bits du mot initial 101. Dans le cas où un ECC linaire est utilisé, ce module effectue le produit matriciel H·V, où H est la matrice de parité caractérisant le code auquel appartient le mot initial 101 et V c'est le mot initial 101. L'implémentation du calcul de ce produit matriciel est réalisée selon des techniques connues. Lorsque le mot initial 101 ne contient aucune erreur, le module de génération de syndrome 110 produit un syndrome 103 qui est un vecteur nul ; par contre, lorsque le mot initial 101 contient une erreur sur au moins 1 bit, alors le syndrome 103 est un vecteur non nul. Si la distance minimale de Hamming du code ayant servi à la génération du mot initial 101 est égale à 4, alors toutes les erreurs doubles produisent des syndromes différents des syndromes produits par les erreurs simples. Si le code auquel appartient le mot initial 101 est imparfait et caractérisé par une distance minimale de Hamming égale à 3, alors une fraction non nulle des erreurs doubles produit des syndromes différents des syndromes produits par les erreurs simples..

Le module de test 120 est adapté à recevoir le mot 102 indicateur de confiance et à produire en sortie un signal binaire. Dans l'exemple, le module de test 120 indique via le signal de sortie si ce mot 102 contient plus d'un bit égal à un 1-logique, ce qui signale la présence de plus d'un bit avec un faible niveau de confiance dans le mot initial 101. Un homme du métier peut choisir parmi plusieurs mises en oeuvre possibles d'un tel module. Selon un autre mode de réalisation du dispositif selon l'invention, le dispositif ne comprend pas de module de test 120 distinct, le test étant effectué par le module de sélection d'erreur double 130.

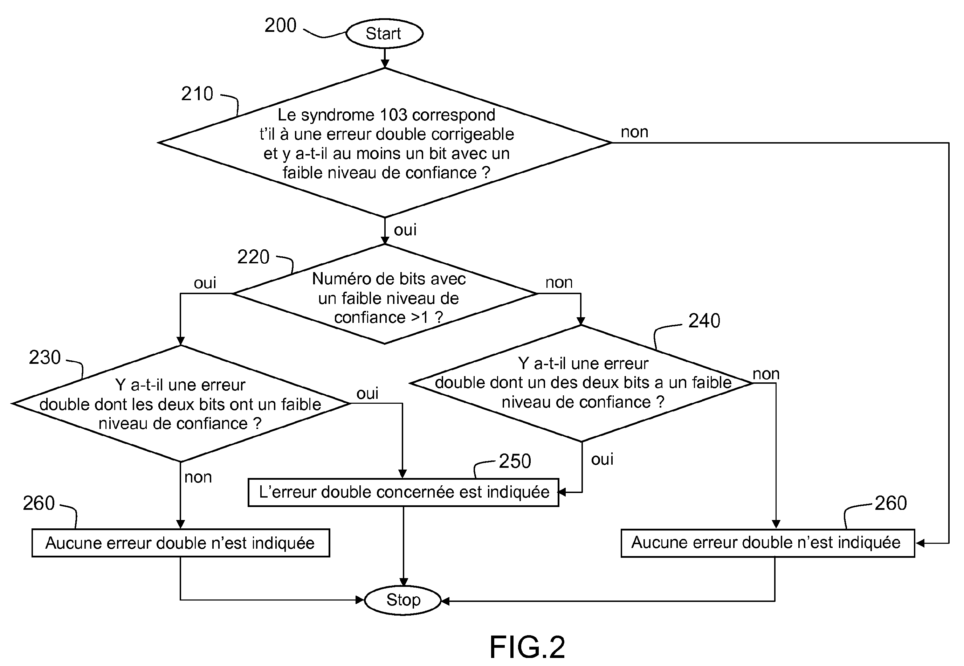

Le module de sélection d'erreur double 130 est configuré pour recevoir le mot indicateur de confiance 102, le syndrome 103 produit par le module 110 décrit plus haut et la sortie binaire du module 120. Lorsque le syndrome 103 produit par le module 110 est différent de tous les syndromes produits par une erreur simple et que le nombre de bits de faible confiance indiqué par le mot 102 est supérieur à 0, le module 130 permet, en exploitant l'information contenue dans le mot indicateur de confiance 102, de déterminer parmi les erreurs doubles possiblement contenues dans le mot initial 101, laquelle s'est produite. Un exemple de procédé mis en oeuvre par le module de sélection d'erreur double 130 est décrit plus loin en regard de la figure 2.

Le module de sélection d'erreur simple 140, relié en sortie du module de génération de syndrome 110, permet d'identifier une erreur simple dans le cas où le syndrome calculé par le module 110 correspond à une telle erreur. Le module 140 est adapté à sélectionner le bit affecté par une erreur simple dans le mot initial en fonction du syndrome issu dudit générateur de syndrome. La mise en oeuvre d'un tel module 140 est connue de l'homme du métier.

Le module de correction d'erreur 150, recevant le mot de code 101 et alimenté par le module de sélection d'erreur simple 140 et par le module de sélection d'erreur double 130, permet la correction des erreurs simples ou doubles affectant le mot initial 101 en utilisant les informations fournies par l'un de ces deux modules 130, 140 indiquant la position des bits erronés. Par exemple, si le module de sélection d'erreur 140 indique que le bit d'ordre n est faux, le module de correction d'erreur 150 effectue la correction en inversant la valeur de ce bit d'ordre n, le passant de 0 à 1 ou de 1 à 0 en fonction de la valeur de ce bit « faux » fournie par le mot de code 101 en entrée. Ainsi, si ce bit « faux » est à 1, on le passe à la valeur 0. L'implémentation d'un tel module 150 est connue de l'homme de l'art. Le module de correction 150 délivre en sortie le mot corrigé 104.

L'ensemble formé par les modules de génération de syndrome 110, de sélection d'erreur simple 140 et de correction d'erreur simple 150 s'apparente aux fonctions remplies par un module de type SEC (« Single Error Correction »), connu par ailleurs.

Dans le cas où la distance minimale de Hamming du code auquel appartient le mot 101 est égale à 4 et toutes les erreurs doubles produisent des syndromes différents des syndromes produits par les erreurs simples, le dispositif de la figure 1 permet la correction de toutes les erreurs doubles.

La figure 2 présente un exemple de procédé selon l'invention pour sélectionner une erreur double parmi plusieurs erreurs doubles produisant un même syndrome. Par exemple, ce procédé peut être exécuté par le module 130 de sélection d'erreur double des bits à inverser, à l'aide du module de test 120, modules présentés plus haut en regard de la figure 1. Ce procédé est nécessaire seulement si le même syndrome 103 peut être généré par plusieurs erreurs doubles différentes, ce qui est généralement le cas lorsque la distance minimale de Hamming entre les mots du code est inférieure à 5.

Le procédé exploite le mot indicateur de confiance 102 et le nombre de bits qui sont affectés d'un faible niveau de confiance pour sélectionner une erreur double dans le mot initial 101 parmi plusieurs erreurs doubles générant le même syndrome 103.

Dans une première étape 210, on ne sélectionne pas une erreur double si le syndrome 103 ne correspond pas à une erreur double détectable ou s'il n'y a aucun bit avec un faible niveau de confiance dans le mot de code 101. Une erreur double est considérée comme détectable si elle génère un syndrome différent de tous les syndromes produits par une erreur simple. Dans l'exemple, cette première étape effectue le test suivant : le syndrome 103 généré par le module 110 correspond-il à une erreur double détectable et y a t-il au moins un bit avec un faible niveau de confiance selon la donnée indicative de confiance 102 ? Il est à noter que le test déterminant s'il y a au moins un bit de faible confiance dans le mot initial peut être exécuté par les modules 120 ou 130 illustrés en figure 1. La première étape 210 indique également que seules les erreurs doubles qui correspondent au syndrome 103 sont considérées. Lorsque le test de la première étape 210 est positif, on passe à une deuxième étape 220. Dans le cas contraire, aucune erreur double n'est indiquée 260.

La deuxième étape 220 effectue un test sur le nombre de bits avec un faible niveau de confiance dans le mot initial 101 . Dans le cas où cette deuxième étape 220 de test indique que le mot initial 101 ne contient pas plus d'un bit avec un faible niveau de confiance, on passe à une troisième étape 240 effectuant le test suivant : existe-t-il une erreur double correspondant au syndrome 103 et dont un des deux bits a un faible niveau de confiance ? Autrement dit, existe-t-il un couple {mot de code, erreur double}, pour lequel le mot de code affecté par cette erreur double génère le syndrome 103, et pour lequel un bit parmi les deux bits affectés par l'erreur correspond au bit dont le niveau de confiance est signalé comme faible dans le mot initial 101 ?

Dans le cas où la deuxième étape de test 220 indique que le mot initial 101 contient plus d'un bit affecté d'un faible niveau de confiance, elle est suivie d'une troisième étape de test alternative 230 permettant de choisir une erreur double si les deux bits qu'elle affecte ont un faible niveau de confiance. Le test effectué est le suivant : existe t-il une erreur double dont les deux bits correspondent à des bits de faible confiance dans le mot initial 101 ? Autrement dit, existe-t-il un couple {mot de code, erreur double}, pour lequel le mot de code affecté par cette erreur double génère le syndrome 103, et pour lequel les deux bits affectés par l'erreur correspondent à des bits dont le niveau de confiance est signalé comme faible dans le mot initial 101 ? Ce cas correspond au cas le plus favorable pour choisir une erreur double, puisqu'il y a concordance entre deux bits de faible confiance et au moins l'une des erreurs double pouvant être à l'origine du syndrome 103 issu du mot initial 101. Par exemple, pour un mot initial égal à « 00110101 » et un mot indicateur de confiance égal à « 01100010 », s'il existe un mot du code parmi les mots suivants : « 01010101 », « 01110111 », « 00010111 », alors ce mot de code est considéré comme le mot sans erreur à l'origine du mot initial. Dans l'exemple, si « 00010111 » est un mot de code, les deux bits erronés qui diffèrent par rapport au mot initial sont considérés comme les bits erronés et sont donc sélectionnés.

Pour ces deux troisièmes étapes 230, 240, lorsque le résultat du test est positif, l'erreur double est indiquée 250. Lorsque le résultat est négatif, aucune erreur double n'est indiquée 260.

Dans une implémentation matérielle, toutes ces étapes qui se succèdent séquentiellement ou des sous-ensembles formés par certaines de ces étapes peuvent être exécutés de manière concurrente.

## Revendications

1. Procédé de détermination des deux bits erronés d'une erreur double dans un mot binaire initial (101) issu d'un code muni d'une distance minimale de Hamming égale à 3 ou 4, apte à sélectionner une erreur double parmi plusieurs erreurs doubles produisant un même syndrome, le procédé comprenant une étape de réception d'une donnée indicative (102) d'un niveau binaire de confiance, faible ou fort, attribué à chacun des bits d'au moins une partie du mot initial (101), une étape de génération du syndrome (103) à partir du mot initial (101) et une étape pour déterminer si ledit syndrome (103) est celui d'un mot de code affecté par une erreur double, **caractérisé en ce qu'**il comporte au moins les étapes suivantes :
• une deuxième étape (220), de test sur le nombre de bits avec un faible niveau de confiance dans le mot initial (101),
• si le test indique que le mot initial (101) contient plus d'un bit affecté d'un faible niveau de confiance, alors on exécute une troisième étape (230), dans laquelle
• on regarde s'il existe un couple {mot de code, erreur double }, pour lequel le mot de code affecté par cette erreur double génère le syndrome (103) et pour lequel les deux bits affectés par l'erreur correspondent à des bits dont le niveau de confiance est signalé comme faible dans le mot initial (101), si oui alors on choisit (250) lesdits deux bits comme bits erronés afin d'être corrigés,
• si le test indique que le mot initial ne contient pas plus d'un bit avec un faible niveau de confiance, on exécute une troisième étape alternative (240) effectuant le test suivant: existe-t-il un couple {mot de code, erreur double}, pour lequel le mot de code affecté par cette erreur double génère le syndrome (103), et pour lequel un bit parmi les deux bits affectés par l'erreur correspond au bit dont le niveau de confiance est signalé comme faible dans le mot initial (101), et s'il existe un tel couple, alors on choisit lesdits deux bits comme bits erronés afin d'être corrigés.

2. Procédé selon la revendication 1, comprenant une étape préalable de test (210) où l'on vérifie si le syndrome (103) issu du mot initial (101) correspond à celui d'une erreur double générant un syndrome différent de tous les syndromes produits par une erreur simple et si au moins un bit du mot initial (101) est affecté d'un faible niveau de confiance; si le test est négatif, aucun bit erroné n'est choisi afin d'être corrigé.

3. Procédé de correction d'une erreur double dans un mot binaire initial (101) comprenant les étapes du procédé de détermination selon l'une quelconque des revendications précédentes, et une étape d'inversion (150) du ou des bits erronés choisis.

4. Procédé de correction des bits erronés dans un mot binaire initial affecté d'une erreur simple ou d'une erreur double et issu d'un code muni d'une distance minimale de Hamming égale à 3 ou 4, dans lequel lorsque le syndrome (103) issu du mot initial (101) correspond à une erreur double, générant un syndrome différent de tous les syndromes produits par une erreur simple, on exécute le procédé de correction d'une erreur double selon la revendication 3, et dans lequel lorsque ledit syndrome (103) correspond à une erreur simple, on exécute une correction d'erreur simple sur le mot initial (101).

5. Dispositif de correction de deux bits erronés d'une erreur double dans un mot initial binaire (101) issu d'un code muni d'une distance minimale de Hamming égale à 3 ou 4, le dispositif étant apte à exécuter les étapes du procédé selon l'une des revendications 1 à 4, étant apte à recevoir une donnée indicative (102) d'un niveau binaire de confiance, faible ou fort, attribué à chacun des bits d'au moins une partie du mot initial (101), le dispositif comprenant un générateur de syndrome (110) alimenté par le mot initial (101) et des moyens de correction sélective de bits (150) du mot initial (101), le dispositif comprenant un module de test (120) apte à effectuer l'étape de test (220) de la revendication 1, un module de sélection d'une erreur double (130) apte à effectuer la troisième étape (230) de la revendication 1, choisissant ainsi deux bits erronés, et un module de sélection d'erreur simple (140) apte à effectuer la troisième étape alternative (240) de la revendication 1, choisissant ainsi deux bits erronés, les moyens de correction sélective (150) étant adaptés à corriger les deux bits choisis par la troisième étape ou la troisième étape alternative.

6. Module mémoire comprenant un dispositif de correction selon la revendication 5.

## Patentansprüche

1. Verfahren zur Bestimmung der zwei fehlerhaften Bits eines Doppelfehlers in einem binären Ausgangswort (101) aus einem Code mit einer minimalen Hamming-Distanz von gleich 3 oder 4, imstande, aus mehreren Doppelfehlern, die dasselbe Syndrom generieren, einen Doppelfehler auszuwählen, wobei das Verfahren einen Empfangsschritt einer indikativen Angabe (102) eines schwachen oder starken binären Vertrauensniveaus, zugewiesen jedem der Bits mindestens eines Teils des Ausgangsworts (101), einen Generierungsschritt des Syndroms (103) aus dem Ausgangswort (101) und einen Bestimmungsschritt, ob das Syndrom (103) ein Syndrom eines durch einen Doppelfehler zugewiesenen Codeworts ist, umfasst, **dadurch gekennzeichnet, dass** es mindestens die folgenden Schritte umfasst:
• einen zweiten Testschritt (220) für die Anzahl von Bits mit einem schwachen Vertrauensniveau im Ausgangswort (101),
• wenn der Test ergibt, dass das Ausgangswort (101) mehr als ein zugewiesenes Bit mit einem schwachen Vertrauensniveau enthält, Durchführung eines dritten Schritts (230), bei dem
• geprüft wird, ob es ein Paar {Codewort, Doppelfehler} gibt, für welches das durch diesen Doppelfehler zugewiesene Codewort das Syndrom (103) generiert und für welches die beiden fehlerhaft zugewiesenen Bits Bits entsprechen, deren Vertrauensniveau im Ausgangswort (101) als schwach gekennzeichnet ist, wenn ja, werden die zwei Bits als fehlerhafte Bits ausgewählt (250), um sie zu korrigieren,
• wenn der Test ergibt, dass das Ausgangswort nicht mehr als ein Bit mit einem schwachen Vertrauensniveau enthält, Durchführung eines dritten alternativen Schritts (240), bei dem der folgende Test durchgeführt wird: gibt es ein Paar {Codewort, Doppelfehler}, für welches das durch diesen Doppelfehler zugewiesene Codewort das Syndrom (103) generiert und für welches ein Bit der die beiden fehlerhaft zugewiesenen Bits dem Bit entspricht, dessen Vertrauensniveau im Ausgangswort (101) als schwach gekennzeichnet ist, und wenn es ein derartiges Paar gibt, werden die zwei Bits als fehlerhafte Bits ausgewählt, um korrigiert zu werden.

2. Verfahren nach Anspruch 1, umfassend einen vorherigen Testschritt (210), bei dem überprüft wird, ob das vom Ausgangswort (101) ausgegebene Syndrom (103) dem eines Doppelfehlers entspricht, der ein Syndrom generiert, das sich von allen von einem einfachen Fehler hervorgerufenen Syndromen unterscheidet und wenn mindestens ein Bit des Ausgangsworts (101) einem schwachen Vertrauensniveau zugewiesen ist; wenn der Test negativ ist, wird kein fehlerhaftes Bit zwecks Korrektur ausgewählt.

3. Korrekturverfahren eines Doppelfehlers in einem binären Ausgangswort (101), umfassend die Schritte des Bestimmungsverfahrens nach einem der vorangehenden Ansprüche und einen Umkehrschritt (150) des oder der ausgewählten fehlerhaften Bits.

4. Korrekturverfahren von fehlerhaften Bits in einem binären Ausgangswort mit einem einfachen Fehler oder einem Doppelfehler aus einem Code mit einer minimalen Hamming-Distanz von gleich 3 oder 4, wobei, wenn das vom Ausgangswort (101) ausgegebene Syndrom (103) einem Doppelfehler entspricht, der ein Syndrom generiert, das sich von allen von einem einfachen Fehler hervorgerufenen Syndromen unterscheidet, das Korrekturverfahren eines Doppelfehlers nach Anspruch 3 durchgeführt wird, und wobei, wenn das Syndrom (103) einem einfachen Fehler entspricht, eine Korrektur eines einfachen Fehlers im Ausgangswort (101) durchgeführt wird.

5. Korrekturvorrichtung von zwei fehlerhaften Bits eines Doppelfehlers in einem binären Ausgangswort (101) aus einem Code mit einer minimalen Hamming-Distanz von gleich 3 oder 4, wobei die Vorrichtung imstande ist, die Schritte des Verfahrens nach einem der Ansprüche 1 bis 4 durchzuführen, wobei sie imstande ist, eine indikative Angabe (102) eines schwachen oder starken binären Vertrauensniveaus zu empfangen, zugewiesen jedem der Bits mindestens eines Teils des Ausgangsworts (101), wobei die Vorrichtung einen mit dem Ausgangswort (101) versorgten Syndromgenerator (110) und Mittel für die selektive Korrektur von Bits (150) des Ausgangsworts (101) umfasst, wobei die Vorrichtung ein Testmodul (120), das imstande ist, einen Testschritt (220) von Anspruch 1 durchzuführen, ein Auswahlmodul eines Doppelfehlers (130), das imstande ist, den dritten Schritt (230) von Anspruch 1 durchzuführen, durch Auswahl von zwei fehlerhaften Bits, und ein Auswahlmodul eines einfachen Fehlers (140), das imstande ist, den dritten alternativen Schritt (240) von Anspruch 1 durchzuführen, durch Auswahl von zwei fehlerhaften Bits, umfasst, wobei die Mittel für die selektive Korrektur (150) ausgebildet sind, die zwei im dritten Schritt oder im dritten alternativen Schritt ausgewählten Bits zu korrigieren.

6. Speichermodul, umfassend eine Korrekturvorrichtung nach Anspruch 5.

## Claims

1. Method for determining the two erroneous bits of a double error in an initial binary word (101) originating from a code provided with a minimal Hamming distance equal to 3 or 4, capable of selecting a double error from a plurality of double errors which produce the same syndrome, the method comprising a step of receiving an item of data (102) which is indicative of a low or high binary confidence level which is attributed to each of the bits of at least a portion of the initial word (101), a step of generating the syndrome (103) from the initial word (101) and a step of determining whether the syndrome (103) is that of a code word affected by a double error, **characterised in that** it comprises at least the following steps:
• a second test step (220) relating to the number of bits with a low confidence level in the initial word (101),
• if the test indicates that the initial word (101) contains more than one bit affected by a low confidence level, then a third step (230) is carried out,
wherein
• it is considered whether there is a pair {code word, double error} for which the code word affected by this double error generates the syndrome (103) and for which the two bits affected by the error correspond to bits whose confidence level is signalled as being low in the initial word (101), if yes then the said two bits are selected (250) as being erroneous bits in order to be corrected,
• if the test indicates that the initial word contains no more than one bit with a low confidence level, a third alternative step (240) is carried out implementing the following test: is there a pair {code word, double error} for which the code word affected by this double error generates the syndrome (103), and for which a bit from the two bits affected by the error corresponds to the bit whose confidence level is signalled as being low in the initial word (101) and, if there is such a pair, then the said two bits are selected as being erroneous bits in order to be comected.

2. Method according to claim 1, comprising
a preliminary test step (210) in which it is verified if the syndrome (103) originating from the initial word (101) corresponds to that of a double error generating a syndrome which is different from all the syndromes produced by a single error and if at least one bit of the initial word (101) is affected by a low confidence level; if the test is negative, no erroneous bit is selected to be corrected.

3. Method for correcting a double error in an initial binary word (101) comprising the steps of the determination method according to either of the preceding claims, and a step (150) of inverting the erroneous bit(s) selected.

4. Method for correcting the erroneous bits in an initial binary word which is affected by a single error or a double error and which originates from a code which is provided with a minimum Hamming distance which is equal to 3 or 4, wherein, when the syndrome (103) originating from the initial word (101) corresponds to a double error, generating a syndrome which is different from all the syndromes produced by a single error, the method for correcting a double error is carried out in accordance with claim 3, and wherein, when the syndrome (103) corresponds to a single error, a single error correction is carried out on the initial word (101).

5. Device for correcting two erroneous bits of a double error in a binary initial word (101) originating from a code provided with a minimum Hamming distance equal to 3 or 4, the device being capable of carrying out the steps of the method according to any one of claims 1 to 4, being capable of receiving an item of data (102) which is indicative of a low or high binary confidence level which is attributed to each of the bits of at least a portion of the initial word (101), the device comprising a syndrome generator (110) which is supplied by the initial word (101) and means for selective correction of bits (150) of the initial word (101), the device comprising a test module (102) which is capable of carrying out the test step (220) of claim 1, a module for selecting a double error (130) which is capable of carrying out the third step (230) of claim 1, thereby selecting two erroneous bits, and a module (140) for selecting a single error which is capable of carrying out the third alternative step (240) of claim 1, thereby selecting two erroneous bits, the means (150) for selective correction being capable of correcting the two bits selected by the third step or the third alternative step.

6. Storage module comprising a correction device according to claim 5.
